# FASCICULE DE BREVET EUROPEEN

(11) **EP 3 312 850 B1**
(45) Date de publication et mention de la délivrance du brevet: **13.02.2019**
(21) Numéro de dépôt: 17179925.7
(22) Date de dépôt: 06.07.2017
(51) Int. Cl.: H01B 17/00, H01B 17/12

(54) **ISOLATEUR COMPOSITE POUR LIGNES ELECTRIQUES AERIENNES AVEC UN DETECTEUR DE COURANT DE FUITE PROTEGE**
VERBUNDISOLATOR FÜR ELEKTRISCHE OBERLEITUNGEN MIT EINEM GESCHÜTZTEN STROMLECKDETEKTOR
A COMPOSITE INSULATOR FOR AN OVERHEAD POWER LINE WITH A PROTECTED LEAKAGE CURRENT DETECTOR

(30) Priorité: 18.10.2016 FR 1660088
(43) Date de publication de la demande: 25.04.2018
(73) Titulaire: Sediver SA, 92017 Nanterre (FR)
(72) Inventeur: COULLOUDON, François, 75015 PARIS (FR); VIRLOGEUX, Fabien, 03700 BELLEVILLE SUR ALLIER (FR)
(74) Mandataire: Prugneau, Philippe

(56) Documents cités:
- EP-A1- 2 884 292
- FR-A- 1 553 917
- FR-A1- 2 574 979

## Description

### Domaine technique

Le domaine de l'invention est celui des isolateurs pour lignes électriques aériennes à haute et très haute tension.

L'invention concerne en particulier un isolateur composite pour lignes électriques aériennes, comprenant une âme rigide s'étendant axialement entre deux armatures d'accrochage et sur laquelle est posée une enveloppe à ailettes en matériau synthétique isolant électriquement.

### Technique antérieure

Les isolateurs pour lignes électriques aériennes sont destinés à maintenir en l'air des lignes électriques sur un pylône.

Un isolateur pour lignes électriques aériennes se présente généralement sous la forme d'une chaine d'éléments diélectriques.

Les isolateurs composites pour lignes électriques aériennes comprennent un jonc en fibre de verre sur lequel est moulée ou enfilée une enveloppe formant des ailettes en forme d'assiette en matériau synthétique isolant électriquement.

Il est connu que ces isolateurs pour lignes électriques aériennes sont soumis aux intempéries, pluie ou brouillard salin par exemple, et à la pollution de l'air, d'origine naturelle ou industrielle, et des grains de matière peuvent se déposer sur la surface des isolateurs.

Lorsque la couche de saleté devient humide, elle se transforme en électrolyte conducteur ce qui peut donner naissance à un courant de fuite superficiel circulant sur la surface de l'isolateur.

Dans ce cas, les isolateurs ne sont plus efficaces et ils ont tendance à vieillir prématurément.

Ainsi, les industriels cherchent à détecter et mesurer les courants de fuite superficiels sur ce type d'installation.

Le document de brevet EP 2884292 présente un dispositif de détection des courants de fuite superficiels sur des isolateurs en verre ou céramique du type capot/tige.

Ce dispositif comprend une unité de détection qui peut se monter sur l'élément diélectrique de tête de la chaine d'éléments diélectriques de l'isolateur pour lignes électriques aériennes.

Ce dispositif connu comprend un premier anneau conducteur qui se fixe autour du capot et qui est en contact avec la surface du diélectrique, un second anneau conducteur de mise à la terre qui se fixe autour du capot au dessus du premier anneau et un boitier de mesure électronique relié aux deux anneaux conducteurs pour détecter et mesurer le courant de fuite.

Cet agencement présente l'inconvénient d'être lui aussi soumis à la pollution de l'air et des pluies, en particulier les anneaux conducteurs se trouvent directement exposés aux conditions environnementales par exemple à la pluie.

Il en résulte que le dispositif de détection et de mesure des courants de fuite superficiels sur la surface des éléments diélectriques peut présenter des défaillances de détection et de mesure.

C'est pourquoi les fabricants d'isolateurs pour lignes électriques aériennes cherchent à développer des isolateurs comprenant des dispositifs de détection de courants de fuite superficiels qui soient plus fiables.

### Exposé de l'invention

Le but de l'invention est donc de proposer un isolateur pour lignes électriques aériennes, ici de type composite, avec un dispositif de détection de courants de fuite superficiels d'une autre conception.

A cet effet, l'invention a pour objet un isolateur composite pour lignes électriques aériennes, comprenant une âme rigide s'étendant axialement entre deux armatures d'accrochage et sur laquelle est posée une enveloppe à ailettes en matériau synthétique isolant électriquement, caractérisé en ce qu'il comprend un dispositif de détection des courants de fuite superficiels comportant une bague annulaire métallique conductrice électriquement qui entoure l'enveloppe entre une ailette d'extrémité de l'enveloppe qui est adjacente à une des deux armatures et une autre ailette de l'enveloppe adjacente à cette ailette d'extrémité, l'ailette d'extrémité s'étendant radialement en surplomb au dessus de la bague et la bague étant connectée à un fil conducteur qui traverse l'ailette d'extrémité pour être raccordée à un circuit électronique du dispositif de détection.

L'isolateur composite pour lignes électriques aériennes selon l'invention peut présenter les particularités suivantes :
- la bague peut être une bride démontable ;
- il peut être prévu que dans un isolateur composite pour lignes électriques aériennes avec un nombre N d'ailettes prédéfini pour une certaine ligne de fuite caractéristique de l'isolateur, l'ailette d'extrémité est une ailette supplémentaire aux N ailettes.

L'idée à la base de l'invention est donc d'ajouter un ailette supplémentaire dans la chaine des ailettes constituant l'enveloppe isolante synthétique d'un isolateur composite et de placer la bague conductrice du dispositif de mesure des courants de fuite superficiels sous cette ailette supplémentaire.

Quand l'isolateur composite est en service, l'isolateur s'étend sensiblement à la verticale et l'ailette supplémentaire adjacente à l'armature supérieure ancrée au pylône se trouve au-dessus des autres ailettes de l'isolateur et sert d'ombrelle à la bague pour la protéger des ruissellements.

Cette ailette supplémentaire est traversée par un câble électrique du dispositif de détection. Toutefois, comme il s'agit de l'ailette supplémentaire, cela ne modifie pas l'isolation électrique de la ligne.

Il faudra prévoir en première monte l'ajout de l'ailette supplémentaire sur l'âme de l'isolateur dont la longueur sera adaptée pour recevoir cette ailette supplémentaire.

### Description sommaire des dessins

La présente invention sera mieux comprise et d'autres avantages apparaîtront à la lecture de la description qui suit et des dessins annexés dans lesquels :
- la figure 1 est une illustration schématique d'un isolateur composite pour lignes électriques aériennes sur un pylône pour supporter une ligne électrique aérienne ;
- la figure 2A est une illustration schématique d'une partie d'un élément diélectrique de type composite ;
- la figure 2B montre en coupe axiale la partie d'un élément diélectrique de type composite de la figure 2A avec une ailette d'extrémité équipée d'une bague annulaire conductrice ;
- la figure 2C montre plus en détail en coupe axiale l'ailette d'extrémité.

### Description des modes de réalisation

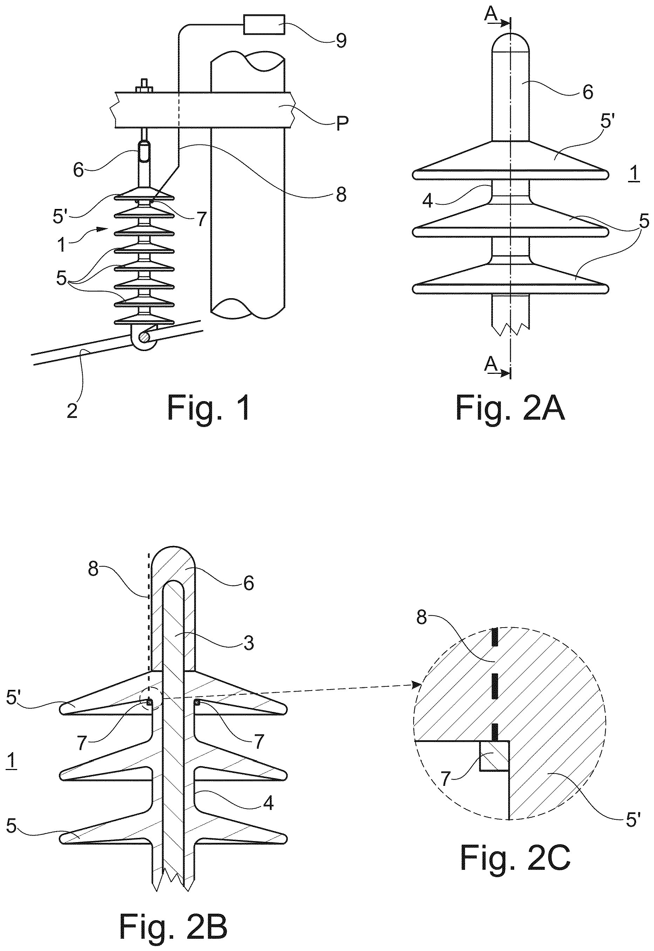

La figure 1 illustre de façon très schématique un isolateur 1 composite de suspension formé d'une chaine de diélectriques moulés 5,5' pouvant soutenir en l'air une ligne électrique aérienne 2 haute tension sur un pylône P.

Comme illustré sur les figures 2A et 2B, l'isolateur 1 comporte une âme 3 en forme de jonc qui est rigide et qui s'étend axialement entre deux armatures (6) d'accrochage métalliques, dont l'armature d'accrochage qui vient se fixer au pylône.

Le jonc peut être en fibre de verre imprégnée de résine, donnant à l'isolateur 1 sa tenue mécanique.

L'isolateur 1 comporte une enveloppe 4 en matériau synthétique isolant électriquement posée sur le jonc et formant des ailettes.

L'enveloppe 4 peut être en résines cycloaliphatiques, en caoutchoucs synthétiques comme du silicones ou éthylpropyldimonomère (EPDM), ou encore en polytétrafluoroéthylènes (Téflon).

L'enveloppe 4 peut être moulée directement sur le jonc ou encore emmanchée sur le jonc.

L'isolateur 1 montré sur la figure 1 présente ici sept ailettes indiquées par la référence 5 disposées en série qui assure la ligne de fuite caractéristique de l'isolateur 1 et une ailette désignée par la référence 5' qui est à l'extrémité de l'isolateur 1 proche du pylône P.

Cette ailette 5' ne participe pas à la ligne de fuite caractéristique de l'isolateur 1. Cette ailette 5' sert d'ombrelle pour une bague 7 annulaire d'un dispositif de détection des courants de fuite superficiels qui peuvent circuler sur la surface extérieure de l'enveloppe 4.

La bague 7 est un anneau métallique conducteur électriquement qui est serré autour de l'enveloppe 4 entre l'ailette 5' et l'ailette 5 adjacente à celle-ci.

La bague 7 est plaquée sous la surface inférieure de l'ailette 5' pour intercepter le courant de fuite superficiel (de quelques milliampères) qui transite en direction de l'armature 6.

L'ailette 5' s'étend donc radialement en surplomb au-dessus de la bague 7 comme une ombrelle.

La bague 7 est reliée par un fil 8 conducteur électrique à un boitier électronique 9 du dispositif de détection, par exemple un circuit électronique de transformation du courant de fuite en tension, ce boîtier électronique 9 fournissant ensuite le signal de tension à une unité de mesure qui peut être distante du boîtier électronique 9.

Comme encore visible sur la figure 2B, l'ailette 5' d'extrémité est traversée par le fil 8 qui court ensuite le long de l'armature 6.

La bague 7 est une bride démontable comme un collier "serflex" pour pouvoir être remplacée lors d'un processus de maintenance par exemple.

Comme illustré sur la figure 2C, la bague 7 peut avoir une section carrée pour présenter une surface périphérique intérieure directement en contact à la fois avec la surface extérieure cylindrique de l'enveloppe 4 entre deux ailettes 5 et la surface extérieure annulaire de l'ailette 5' d'extrémité.

Grace au bord périphérique extérieur profilé de l'ailette 5' d'extrémité, il se produit un ruissellement naturel par gravité de l'eau de pluie sans atteindre la bague 7 qui est ainsi bien protégée.

## Revendications

1. Isolateur (1) composite pour lignes électriques aériennes, comprenant une âme (3) rigide s'étendant axialement entre deux armatures (6) d'accrochage et sur laquelle est posée une enveloppe (4) à ailettes (5, 5') en matériau synthétique isolant électriquement, **caractérisé en ce qu'**il comprend un dispositif de détection des courants de fuite superficiels comportant une bague (7) annulaire métallique conductrice électriquement entourant ladite enveloppe (4) entre une ailette (5') d'extrémité adjacente à une desdites deux armatures (6) et une autre ailette (5) adjacente à ladite ailette (5') d'extrémité, ladite ailette (5') d'extrémité s'étendant radialement en surplomb au dessus de ladite bague (7) et ladite bague (7) étant connectée à un fil (8) conducteur qui traverse ladite ailette (5') d'extrémité pour être raccordée à un boitier électronique (9) dudit dispositif de détection.

2. Isolateur (1) composite pour lignes électriques selon la revendication 1, **caractérisé en ce que** ladite bague (7) est une bride démontable.

3. Isolateur (1) composite pour lignes électriques selon l'une des revendications précédentes, **caractérisé en ce qu'**il est prévu avec un nombre N d'ailettes (5) définissant une certaine ligne de fuite caractéristique de l'isolateur, ladite ailette (5') d'extrémité étant une ailette supplémentaire auxdites N ailettes (5).

## Patentansprüche

1. Verbundisolator (1) für elektrische Oberleitungen, umfassend einen starren Kern (3), der sich axial zwischen zwei Beschlägen (6) zur Befestigung erstreckt, und auf dem eine Hülle (4) mit Rippen (5, 5') aus einem elektrisch isolierenden Kunststoff angeordnet ist, **dadurch gekennzeichnet, dass** er eine Vorrichtung zur Erfassung der oberflächlichen Leckageströme umfasst, umfassend einen elektrisch leitenden ringförmigen metallischen Ring (7), der die Hülle (4) zwischen einer Endrippe (5'), die an einen der zwei Beschläge (6) angrenzt, und einer weiteren Rippe (5), die an die Endrippe (5') angrenzt, umgibt, wobei sich die Endrippe (5') radial überhängend über dem Ring (7) erstreckt, und der Ring (7) an einen leitenden Draht (8), der die Endrippe (5') durchquert, angeschlossen ist, um an ein elektronisches Gehäuse (9) der Erfassungsvorrichtung angeschlossen zu werden.

2. Verbundisolator (1) für elektrische Leitungen nach Anspruch 1, **dadurch gekennzeichnet, dass** der Ring (7) eine abnehmbare Schelle ist.

3. Verbundisolator (1) für elektrische Leitungen nach einem der vorhergehenden Ansprüche, **dadurch gekennzeichnet, dass** er mit einer Anzahl N von Rippen (5) vorgesehen ist, die eine gewisse Leckageleitung, die für den Isolator charakteristisch ist, definieren, wobei die Endrippe (5') eine zusätzliche Rippe zu den N Rippen (5) ist.

## Claims

1. A composite insulator (1) for overhead power lines, the composite insulator comprising a rigid core (3) extending axially between two attachment fittings (6) and having placed thereon a shell (4) having sheds (5, 5') made of electrically insulating synthetic material, the composite insulator being **characterized in that** it includes a detector device for detecting surface leakage currents, the detector device comprising an electrically conductive metal annular ring (7) surrounding said shell (4) between an end shed (5') adjacent to one of said two fittings (6) and another shed (5) adjacent to said end shed (5'), said end shed (5') extending radially over said ring (7), and said ring (7) being connected to a conductive wire (8) that passes through said end shed (5') to be connected to an electronic unit (9) of said detector device.

2. A composite insulator (1) for power lines according to claim 1, **characterized in that** said ring (7) is a removable band.

3. A composite insulator (1) for power lines according to either preceding claim, **characterized in that** it is provided with a number, N, of sheds (5) defining a certain leakage current characteristic of the insulator, with said end shed (5') being a shed that is additional to said N sheds (5).
